Europäisches Patentamt

European Patent Office

Office européen des brevets

(19)

(11) Veröffentlichungsnummer: **0 447 650 A2**

# (12) EUROPÄISCHE PATENTANMELDUNG

(21) Anmeldenummer: 90124628.0

(22) Anmeldetag: **18.12.90**

(51) Int. Cl.5: **H03K 19/00,** H03K 19/08

(30) Priorität: **16.02.90 DE 4005035**

(43) Veröffentlichungstag der Anmeldung:
**25.09.91 Patentblatt 91/39**

(84) Benannte Vertragsstaaten:
**DE FR GB IT NL**

(71) Anmelder: **Siemens Aktiengesellschaft**
**Wittelsbacherplatz 2**
**W-8000 München 2(DE)**

(72) Erfinder: **Barré, Claude, Dipl.-Ing.**
**Implerstrasse 23**
**W-8000 München 70(DE)**

(54) **Integrierbare Schaltung zum Verarbeiten logischer Signale.**

(57) Schnelle Logikschaltungstechniken weisen den Nachteil auf, hohe Verlustleistungen zu erzeugen. Auf jedem integrierten Schaltkreis befinden sich aber auch Schaltelemente, die nicht an den schnellen Schaltvorgängen teilnehmen. Die Reduzierung der Verlustleistung dieser Schaltelemente wird durch Ersatz der Arbeitswiderstände durch Bipolartransistoren und durch Ersatz der schnellen Bipolarschalttransistoren durch MOS-Schalttransistoren erreicht. Beispielsweise ist vorgesehen, einen MOS-Transistor (T3) als Stromquelle, zwei an ihren Sourceanschlüssen verbundene MOS-Schalttransistoren (T1,T2) als Stromschalter und zwei pnp-Bipolartransistoren (T4,T5) als Arbeitswiderstände einzusetzen.

EP 0 447 650 A2

## INTEGRIERBARE SCHALTUNG ZUM VERARBEITEN LOGISCHER SIGNALE

Die Erfindung besteht aus einer integrierbaren Schaltung zum Verarbeiten logischer Signale nach dem Oberbegriff des Patentanspruchs 1.

Die Anzahl der auf einem Chip integrierbaren Schaltelemente ist durch Verfeinerung der Chipstrukturen stets angestiegen. War es beispielsweise zu Beginn der Realisierungsphase von integrierten Schaltungen noch möglich, alle zu einer Funktionsprüfung notwendigen Ein- und Ausgänge einer auf einem Baustein integrierten Gatterschaltung jeweils über einen Anschlußpin nach außen zu führen, so gelingt dies bei hochintegrierten Schaltungen auf Grund einer begrenzten Anzahl von Anschlußpins nicht mehr. Die Konsequenz daraus wäre, daß die auf einem Chip integrierten Schaltungen nicht mehr prüfbar und somit eine detaillierte Fehlererkennung nicht mehr möglich wäre. Um diesem Problem abzuhelfen, bedient man sich einer gemeinsam mit der die gewünschte Funktion realisierenden Schaltung auf dem Chip untergebrachten Prüfschaltungslogik. Mit Hilfe dieser Prüfschaltungslogik ist es möglich, bereits auf dem Chip die relevanten Gatterein- und -ausgänge zu überprüfen und lediglich das Ergebnis einer solchen Überprüfung über einen Anschlußpin nach außen abzugeben. Überprüfungen der Schaltungslogik sind im allgemeinen nicht Bestandteil des regulären Funktionsablaufs der Nutzschaltung. Prüfschaltungen sind lediglich zu bestimmten Zeiten, beispielsweise beim Einschalten aktiv, wodurch unter Umständen die Anforderungen bezüglich Geschwindigkeit nicht so hoch sind, wie die diesbezüglichen Anforderungen an die Nutzschaltung. Hohe Schaltgeschwindigkeiten erreicht man mit der bekannten Schaltungstechnik nur durch hohen permanenten Stromverbrauch. Aus diesem Stromverbrauch resultiert eine hohe Verlustleistung, starke Bauteilerwärmung und um dieser entgegenzuwirken, eine kostspielige Kühlapparatur. Bietet sich eine Möglichkeit, diese hohe Verlustleistung zu reduzieren, so ist es vorteilhaft, diese Möglichkeit zu nutzen. Im Falle der auf einem Chip integrierten Prüflogik ist eine Leistungseinsparung besonders vorteilhaft, da der Anteil der Prüflogikschaltungen an der Anzahl der gesamten auf einem Chip integrierten Schaltungen bei 10 bis 15 % liegt.

Bei Schaltungen, die nach dem Oberbegriff des Patentanspruchs 1 aufgebaut sind, wie beispielsweise in der DE-OS 38 26 574, wird der Stromverbrauch der Schaltung allein durch die Stromquelle bestimmt. Halbiert man beispielsweise die von der Stromquelle gelieferte Stromstärke um die Hälfte, so reduziert sich auch die Verlustleistung um die Hälfte. Die Ausgänge der Schaltung befinden sich in den beiden Stromzweigen zwischen den Arbeitswiderständen und den Hauptstrompfaden der Schalttransistoren. Die beiden möglichen logischen Zustände werden durch das Sperren bzw. Leitendmachen des Hauptstrompfades eines Schalttransistors erzeugt. Im Idealfall - unbelasteter Ausgang - fließt bei gesperrtem Transistorhauptstrompfad durch den Arbeitswiderstand kein Strom. Am Ausgang liegt der Pegel der zweiten konstanten Versorgungsspannung vor. Ist der Hauptstrompfad des Schalttransistors leitend, so fließt der von der Stromquelle bestimmte Strom durch den Hauptstrompfad des Schalttransistors und durch den Arbeitswiderstand. Am Arbeitswiderstand fällt eine Spannung ab, die dem Differenzpegel zwischen den beiden logischen Zuständen am Ausgang entspricht. Dieser Differenzpegel, im folgenden als Hub bezeichnet, darf 95 % seines Maximalwertes nicht unterschreiten, wenn er gut und störungssicher auswertbar sein soll. Abweichend vom Idealzustand fließt aber in den Steuereingang einer der betrachteten Schaltung nachgeschalteten logischen Schaltung ein um den Stromverstärkungsfaktor B kleinerer Strom als im Hauptstrompfad des Eingangsschalttransistors dieser nachgeschalteten Logikschaltung.

Daraus, daß der Hub nur auf 95 % seines Maximalwertes abfallen darf, folgt die Bedingung, daß der Strom im Hauptstrompfad der nachgeschalteten Logikschaltung dividiert durch den Stromverstärkungsfaktor B kleiner als 5 % desjenigen Stromes sein muß, der im Hauptstrompfad der betrachteten Schaltung fließt. Realisierbare Werte des Stromverstärkungsfaktors liegen bei etwa 50. Mit Einsetzen dieses Wertes in die vorgenannte Bedingung, ergibt sich, daß der Strom im Hauptstrompfad der betrachteten Schaltung mindestens 0,4 mal so groß sein muß, wie der Strom im Hauptstrompfad der nachgeschalteten Logikschaltung. Arbeiten mehrere miteinander verbundene Logikschaltungen mit gleich großem Strom im Hauptstrompfad, dann können an einem Ausgang bis zu drei Eingänge einer Logikschaltung angeschlossen werden. Dagegen kann mit dem Ausgang einer Logikschaltung, in deren Hauptstrompfad lediglich das 0,4-fache des sonst üblichen Stromes fließt, nur ein Eingang einer mit vollem Strom arbeitenden Logikschaltung angesteuert werden. Einer Reduzierung der Leistung lediglich um die Hälfte, steht also der Nachteil einer Reduzierung des sogenannten FAN-OUT von ca. 3 auf ca. 1 gegenüber.

Die der vorliegenden Erfindung zugrundeliegende Aufgabe besteht darin, eine Möglichkeit zur Leistungsreduzierung zu schaffen, die nicht gleichzeitig eine Reduzierung des FAN-OUT zur Folge hat.

Diese Aufgabe wird durch die Kombination der Merkmale des Oberbegriffs und der Merkmale im kennzeichnenden Teil des Patentanspruchs 1 gelöst.

Dieser Problemlösung liegt die Erkenntnis zugrunde, daß allein mit der Änderung der Dimensionierung von Arbeitswiderständen und Änderung der Stromaufnahme einer Schaltung die Aufgabe nicht gelöst werden kann. Als Konsequenz dieser Erkenntnis werden bei der vorliegenden Erfindung sämtliche, in typischen Logikschaltungen üblichen Bauelemente gegen andere Bauelemente ausgetauscht, die zudem aus anderen Technologien stammen. Üblicherweise werden, in Schaltungen nach dem Oberbegriff, als Schalt- und Stromquellentransistoren npn-Bipolartransistoren verwendet, die - außerhalb der Sättigung betrieben - eine hohe Betriebsgeschwindigkeit der Logikschaltung gewährleisten. Ersetzt man diese Schalttransistoren durch MOS-Schalttransistoren, so weist eine solche Schaltung zwar nicht mehr die vormals hohe Verarbeitungsgeschwindigkeit auf, schafft aber auf Grund der hochohmigen Gatesteuereingänge Vorteile bezüglich der Reduzierung der Verlustleistung. In Kombination mit dem Wechsel der Schalttransistoren werden die in den Stromzweigen üblichen Arbeitswiderstände gegen Kollektor-Emitter-Strecken von pnp-Bipolartransistoren ausgetauscht. Während die Strom-Spannungskennlinie eines ohmschen Widerstandes einen linearen Verlauf aufweist - der Widerstandswert also stets konstant ist - steigt der Kollektorstrom bei kleiner Kollektor-Emitter-Spannung stark an, um sich bei höheren Kollektor-Emitter-Spannungen kaum mehr zu verändern. Ist also der pnp-Bipolartransistor leitend, zeigt er einen geringen Widerstand, sperrt er, hat er einen sehr großen Widerstandswert. Mit Hilfe dieses als Arbeitswiderstand eingesetzten pnp-Bipolartransistors ist es also möglich, abhängig vom jeweiligen Bedarf, den Wert dieses Arbeitswiderstandes zu verändern. Ist die als Transistor-Hauptstrompfad bezeichnete Drain-Source-Strecke eines MOS-Schalttransistors leitend, so sorgt ein großer Arbeitswiderstand bei geringem Strom für ausreichend großen Hub des Ausgangspegels, bei gesperrter Drain-Source-Strecke des MOS-Schalttransistors gewährleistet dagegen ein niederohmiger Arbeitswiderstand selbst bei relativ niederohmiger Ausgangslast einen geringen Spannungsabfall.

Erreicht wird die zielgerechte Veränderung des Arbeitswiderstandes durch das Verbinden der Basisanschlüsse der pnp-Bipolartransistoren mit dem jeweils anderen Stromzweig. In der vorliegenden Schaltung, die auch als Differenzverstärker betrachtet werden kann, ist stets nur eine der beiden Drain-Source-Strecken der MOS-Schalttransistoren leitend, während die andere sperrt. An den Drainanschlüssen der beiden MOS-Schalttransistoren, die die logischen Ausgänge der Schaltung bilden, liegen stets komplementäre Ausgangszustände vor. Sperrt also der erste Schalttransistor, dann liegt an seinem Drainanschluß annähernd die zweite konstante Versorgungsspannung an. Der pnp-Bipolartransistor, dessen Kollektor-Emitter-Strecke den Arbeitswiderstand für den Stromzweig bildet, in dem sich der zweite MOS-Schalttransistor befindet, wird gesperrt und damit hochohmig, da seine Basis mit dem Drainanschluß des ersten MOS-Schalttransistors verbunden ist. Am Drainanschluß des zweiten MOS-Schalttransistors, der mit dem Basisanschluß des pnp-Bipolartransistors verbunden ist, dessen Kollektor-Emitter-Strecke sich im selben Stromzweig wie der erste MOS-Schalttransistor befindet, liegt relativ niedriges Potential - Low-Pegel - vor. Dieses niedrige Potential macht den pnp-Bipolartransistor leitend bzw. niederohmig.

Diese langsame und stromsparende Schaltung kann vorzüglich in Kombination mit der um den Faktor 100 schnelleren Stromschalterlogik in reiner Bipolartechnik verwendet werden. Der hochohmige Eingangswiderstand des ersten MOS-Schalttransistors belastet den Ausgang einer vorhergehenden Schaltstufe kaum, so daß sie die schnellen Schaltprozesse im Normalbetrieb der integrierten Schaltung nicht stört. Trotz geringer Eigenstromaufnahme auf Grund der veränderbaren Arbeitswiderstände kann die Schaltung eine große Anzahl nachgeschalteter Schaltstufen in reiner Bipolartechnik treiben.

Nachteilig wirkt sich die Stromverstärkung der pnp-Bipolartransistoren aus, da sie zu unterschiedlichen Stromstärken in den beiden Stromzweigen der Schaltung führt. Diese unterschiedlichen Stromstärken bewirken eine Hysterese der Schaltschwelle der Logikschaltung. So kann beispielsweise der zweite MOS-Schalttransistor, an dessen Drainanschluß Low-Pegel (-0,8V) vorliegt, erst bei einer Spannung von -0,1 Volt am Gateanschluß des ersten MOS-Schalttransistors gesperrt werden, also in den High-Zustand (OV) schalten, wohingegen dieser zweite MOS-Schalttransistor erst bei Anlegen von -0,4 Volt am Gateanschluß des ersten MOS-Schalttransistors wieder in den leitenden Zustand versetzt werden kann. Die absoluten Schaltschwellen, die dieser Hysterese zugrundeliegen, hängen - abgesehen von den Versorgungs- und Referenzspannungen - stark davon ab, wie groß die Stromverstärkung der pnp-Bipolartransistoren ist und davon, ob diese Stromverstärkung in beiden pnp-Bipolartransistoren gleich groß ist. Technologisch sind diese, durch die genannten Abhängigkeiten entstandenen Forderungen an die Stromverstärkung der beiden pnp-Bipolartransistoren aber nur unter größten Schwierigkeiten realisierbar, wohingegen durch die Merkmale des Patentanspruchs 2 ein brauchbares Mittel geschaffen ist, die Stromverstärkung und damit die Hysterese zu steuern. Durch das Emitterflächenverhältnis der beiden zu einem Stromspiegel zusammengeschalteten pnp-Bipolartransistoren wird bekanntlich weitgehend unabhängig von den Einzelstromverstärkungen der beteiligten Transistoren die Gesamtstromverstärkung bestimmt. Das Einstellen bestimmter Emitterflächenverhältnisse ist technologisch beherrschbar. Es kann also beim Herstellungsprozeß der Schaltung die gewünschte Hysterese eingestellt oder die Hysterese gänzlich beseitigt werden.

Mit der vorliegenden Schaltung in der bisher beschriebenen Form ist lediglich die Grundfunktion einer logischen Schaltung, ein sogenannter Inverter mit komplementärem Ausgang, realisiert. Diese Grundfunktion wird in bekannten Schaltungen beispielsweise der ECL-Technik (Emitter-Coupled-Logic) zu anderen komplexeren logischen Funktionen erweitert.

Durch das Parallelschalten der Drain-Source-Strecke eines weiteren, ebenfalls als Gattereingang dienenden MOS-Schalttransistors zur Drain-Source-Strecke des als Gattereingang dienenden MOS-Schalttransistors wird die Grundfunktion der Logikschaltung zu einer OR/NOR-Funktion erweitert. Ebenso wie in der bekannten ECL-Technik wird dies durch parallelschalten eines oder mehrerer Hauptstrompfade von Transistoren zum Hauptstrompfad des Eingangsschalttransistors erreicht.

Eine weitere Möglichkeit, mit der beschriebenen Logikschaltung komplexere Logikfunktionen zu realisieren, bietet die in der ECL-Technik mit "Series-Gating" bezeichneten Methode. Mit "Series-Gating" bezeichnet man eine serielle logische Verknüpfung, bei der die Stromschalter übereinander in Serie angeordnet sind und gemeinsam aus einer Stromquelle gespeist werden. Diese Schaltungen, bestehend aus reiner Bipolartechnik bekannte Schaltungstechnik kann auch durch die in Patentanspruch 4 genannten Merkmale in der vorliegenden Erfindung genutzt werden. Es können also durch Einbringen von an ihren Sourceanschlüssen zusammengeschalteten MOS-Schalttransistoren in die Verbindungsstellen zwischen MOS-Schalttransistoren und pnp-Bipolartransistoren NAND/AND-Verknüpfungen, EXOR-Verknüpfungen, Multiplexer, Flip-Flops und Kombinationen sämtlicher Logikverknüpfungen realisiert werden.

In den aus der ECL-Technik bekannten Series-Gating-Schaltungen müssen durch Pegelanpassungsschaltungen die von außen - beispielsweise von benachbarten Gattern - kommenden Logikspannungs- und Referenzspannungspegel je nach Bedarf für die einzelnen in Serie geschalteten Stromschalter verschoben werden. Durch die Verwendung von MOS-Schalttransistoren kann diese Pegelverschiebung entfallen, da durch Variation der Fläche eines MOS-Transistors seine Strom-Spannungskennlinie beeinflußt werden kann. Die an ihren Sourceanschlüssen zusammengeschalteten MOS-Schalttransistoren bilden jeweils einen Stromschalter. Verändert man die Fläche der MOS-Schalttransistoren von einem Stromschalter zum anderen und legt an jeden dieser Stromschalter die gleiche Referenzspannung, dann unterscheiden sich die absoluten Pegel der Schaltschwellen von Stromschalter zu Stromschalter. Pegelschieberschaltungen können also bei konsequenter Ausnutzung dieses Effekts entfallen, wodurch ein weiterer Stromspareffekt erzielt und die für die Pegelschieber sonst notwendige Chipfläche eingespart wird. Durch die mit technologischen Mitteln erreichte Shaltschwellenveränderung der Stromschalter kann auch die Bereitstellung von verschiedenen Referenzspannungspegeln entfallen und eine Referenzspannung gleichzeitig an mehrere in Serie oder parallel angeordnete Stromschaltertransistorpaare angelegt werden.

Mehrere Ausführungsbeispiele der Erfindung werden im folgenden anhand der Zeichnung näher erläutert. Dabei zeigen:

FIG 1 ein typisches ECL-Gatter ohne Emitterfolger an den Ausgängen,

FIG 2 eine erfindungsgemäße Inverterschaltung mit komplementären Ausgängen,

FIG 3 eine Schaltung gemäß FIG 2, die durch zwei Stromspiegeltransistoren erweitert ist,

FIG 4 eine Schaltung gemäß FIG 2 mit einem zweiten MOS-Eingangsschalttransistor,

FIG 5 eine Schaltung gemäß FIG 2 mit einem weiteren Stromschalter.

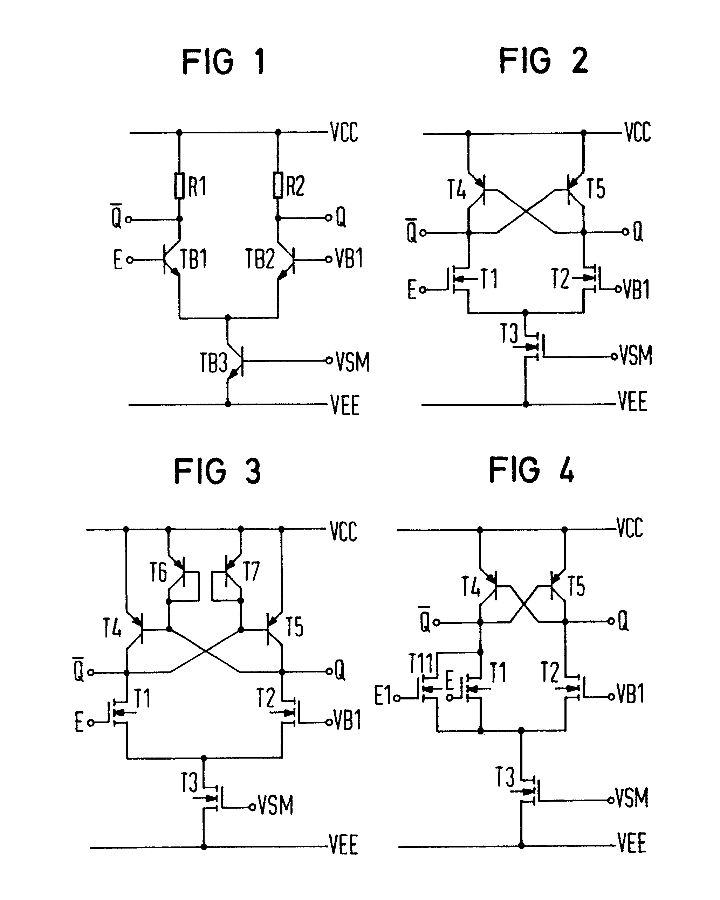

FIG 1 zeigt eine typische Inverterschaltung in CML-Technik. CML-Technik nennt man eine Stromschaltertechnik, die sich von der ECL-Technik lediglich durch die am Ausgang nicht vorhandenen npn-Bipolartransistoren in Emitterfolgerschaltung unterscheidet. Als Stromquelle dient ein npn-Bipolartransistor TB3, dessen Emitteranschluß mit einer konstanten Versorgungsspannung VEE verbunden ist, an dessen Basisanschluß eine die Stromstärke steuernde Referenzspannung VSM anliegt und dessen Kollektoranschluß sowohl mit dem Emitteranschluß eines ersten npn-Bipolarschalttransistors TB1 als auch mit dem Emitteranschluß eines zweiten npn-Bipolartransistors TB2 verbunden ist. Die Kollektoranschlüsse der beiden npn-Bipolarschalttransistoren TB1, TB2 dienen als zueinander komplementäre Ausgänge Q, $\overline{Q}$ der Inverterschaltung und sind jeweils über einen Arbeitswiderstand R1, R2 mit einer zweiten konstanten Versorgungsspannung VCC, die gegenüber der ersten konstanten Versorgungsspannung VEE positiv ist, verbunden.

Mit Hilfe einer zweiten Referenzspannung, die am Basisanschluß des zweiten npn-Bipolarschalttransistors TB2 anliegt, wird die Schaltschwelle des Inverters festgelegt. Den Invertereingang E bildet der Basisanschluß des ersten npn-BipolarschalttransistorsTB1.

FIG 2 zeigt die erfingungsgemäße Schaltung. Die in dieser und in den nachfolgenden Figuren dargestellten MOS-Transistoren sind sogenannte selbstsperrende n-MOS-Transistoren. Ein MOS-Transistor T3 ist mit seinem Sourceanschluß mit der Versorgungsspannung VEE verbunden. Dieser MOS-Transistor wird als Stromquelle verwendet und an seinem Gateanschluß von der Referenzspannung VSM gesteuert. Der Drainanschluß ist mit den Sourceanschlüssen zweier MOS-Schalttransistoren T1, T2 verbunden. Die Drainanschlüsse dieser beiden MOS-Schalttransistoren T1, T2 dienen ebenso wie die Kollektoranschlüsse der npn-BipolarschalttransistorenTB1, TB2 der FIG 1 als komplementäre Gatterausgänge Q, $\overline{Q}$. Der Drainanschluß des ersten MOS-Schalttransistors T1 ist mit dem Kollektoranschluß eines pnp-Bipolartransistors T4 und mit dem Basisanschluß eines zweiten pnp-Bipolartransistors T5 verbunden und der Drainanschluß des zweiten MOS-Schalttransistors T2 ist mit dem Kollektoranschluß des zweiten pnp-Bipolartransistors T5 und mit dem Basisanschluß des ersten pnp-Bipolartransistors T4 verbunden. Die Emitter der beiden pnp-Bipolartransistoren T4, T5 werden von der zweiten konstanten Versorgungsspannung VCC versorgt. Am Gateanschluß des zweiten MOS-Schalttransistors T2 liegt die zweite Referenzspannung VB1, mit der ebenso wie in FIG 1 die Schaltschwelle des Inverters eingestellt wird. Der Gateanschluß des MOS-Schalttransistors T1 bildet den Eingang E des Inverters.

In den FIG 3, 4 und 5 sind vorteilhafte Weiterbildungen der Schaltung nach FIG 2 dargestellt.

In FIG 3 sind zusätzlich ein dritter und ein vierter pnp-Bipolartransistor T6, T7 in die Schaltung eingefügt. Der Basis- und der Kollektoranschluß des dritten pnp-Bipolartransistors T6 ist mit der Basis des ersten pnp-Bipolartransistors T4 verbunden und der Basisanschluß und der Kollektoranschluß des vierten pnp-Bipolartransistors T7 ist mit dem Basisanschluß des zweiten pnp-Bipolartransistors T5 verbunden. Die Emitteranschlüsse der zusätzlich eingefügten pnp-Bipolartransistoren T6, T7 sind mit der zweiten konstanten Versorgungsspannung VCC verbunden. Es bilden also der erste und der dritte pnp-Bipolartransistor T4, T6 und der zweite und der vierte pnp-Bipolartransistor T5, T7 jeweils einen Stromspiegel.

In FIG 4 ist zusätzlich zu der in FIG 2 abgebildeten Schaltung ein MOS-Schalttransistor T11 abgebildet. Sowohl sein Drain- als auch sein Sourceanschluß ist mit dem entsprechenden Anschluß des ersten MOS-Schalttransistors T1 verbunden. Der Gateanschluß des zusätzlich in die Schaltung eingefügten MOS-Schalttransistors T11 bildet einen zweiten Gattereingang E1. Die Eingänge E und E1 bilden bezüglich der Gatterausgänge Q bzw. $\overline{Q}$ die Eingänge eines OR- bzw. NOR-Gatters.

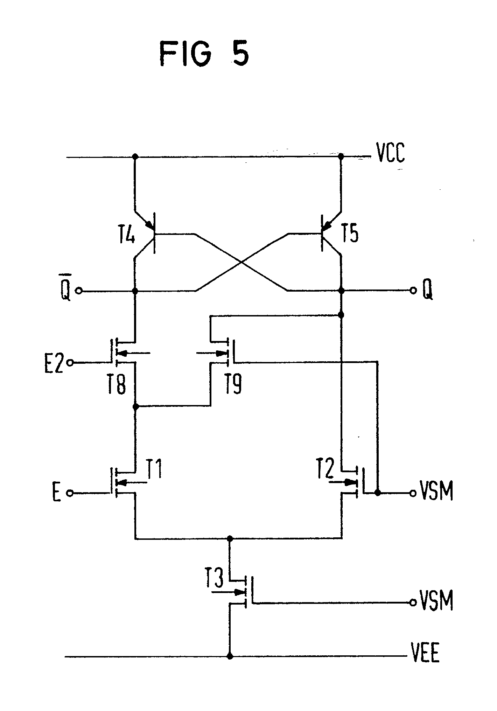

FIG 5 zeigt ein AND- bzw. NAND-Gatter mit dem Eingang E und einem Eingang E2 und den Ausgängen Q bzw. $\overline{Q}$. Zwischen dem komplementären Ausgang $\overline{Q}$ und dem Drainanschluß des ersten MOS-Schalttransistors ist die Drain-Source-Strecke eines dritten MOS-Schalttransistors T8 eingefügt. Dieser MOS-Schalttransistor T8 bildet gemeinsam mit einem vierten MOS-Schalttransistor T9, dessen Sourceanschluß mit dem Sourceanschluß des dritten MOS-Schalttransistors T8 verbunden ist, einen zweiten Stromschalter, der in Serie zum ersten aus den beiden MOS-Schalttransistoren T1, T2 gebildeten Stromschalter angeordnet ist. Auf Grund dieser Serienschaltung wird diese Schaltungsvariante auch als "Series-Gating-Schaltung" bezeichnet. Die Schaltschwelle des zweiten Stromschalters wird durch die Verbindung des Gateanschlusses des vierten MOS-Schalttransistors T9 mit der zweiten Referenzspannung VB1 festgelegt. Der Drainanschluß des vierten MOS-Schalttransistors T9 ist mit dem Ausgang Q verbunden. Die beiden in Serie geschalteten Stromschalter schalten trotz Festlegung der Schaltschwelle mittels einer einzigen Referenzspannung VB1 bei unterschiedlichen absoluten Spannungspegeln. Dies ist möglich, weil die MOS-Schalttransistoren T8, T9 bzw. T1, T2 auf dem Halbleiterchip unterschiedlich große geometrische Flächen beanspruchen.

Anstelle von n-Kanal-MOS-Schalttransistoren und pnp-Bipolartransistoren lassen sich in gleich vorteilhafter Weise auch p-Kanal-MOS-Schalttransistoren und npn-Bipolartransistoren verwenden, wenn die Betriebsspannungen umgepolt werden.

## Patentansprüche

1. Integrierbare Schaltung zum Verarbeiten logischer Signale mit zwei jeweils durch eine Reihenschaltung eines Arbeitswiderstandes mit dem Hauptstrompfad eines Schalttransistors gebildeten Stromzweigen, die an einem Ende gemeinsam aus einer Stromquelle versorgt werden und am anderen Ende mit einer konstanten Versorgungsspannung (VCC) verbunden sind, und bei denen der Steuereingang des jeweiligen Schalttransistors als Gattereingang bzw. als Koppelpunkt für eine eine Gatterschaltschwelle festlegende Referenzspannung (VB1) dient, wobei die Stromquelle mit Hilfe eines am Gateanschluß mit einer zweiten Referenzspannung (VSM) beaufschlagten und am Sourceanschluß von einer zweiten konstanten Versorgungsspannung (VEE) gespeisten MOS-Transistors (T3) realisiert ist, dessen Drainanschluß mit den Sourceanschlüssen zweier MOS-Schalttransistoren (T1, T2) verbunden ist, und wobei der Gateanschluß des ersten MOS-Schalttransistors (T1) als Gattereingang dient und am Gateanschluß des zweiten MOS-Schalttransistors (T2) die Referenzspannung (VB1) anliegt,
**dadurch gekennzeichnet,**
daß als Arbeitswiderstand jeweils die Kollektor-Emitter-Strecke eines Bipolartransistors (T4, T5) dient, dessen Basis vom selben Leitfähingkeitstyp wie der Kanal des ersten und zweiten MOS-Schalttransistors (T1, T2) ist, und daß jeweils der Basisanschluß des einen Bipolartransistors (T4, T5) mit dem Kollektoranschluß des Bipolartransistors (T5, T4) im jeweils anderen Stromzweig verbunden ist.

2. Schaltungsanordnung nach Anspruch 1,
**dadurch gekennzeichnet,**
daß der erste und zweite MOS-Schalttransistor (T1, T2) vom n-Kanal-Typ und die Bipolartransistoren (T4, T5) vom pnp-Typ sind.

3. Schaltungsanordnung nach Anspruch 1 oder 2,
**dadurch gekennzeichnet,**
daß jeweils am Basisanschluß der Bipolartransistoren (T4, T5) ein als Stromspiegel dienender weiterer Bipolartransistor (T6, T7) sowohl mit seinem Basisanschluß als auch mit seinem Kollektoranschluß angeschaltet ist und daß die Emitteranschlüsse der als Stromspiegel dienenden Bipolartransistoren mit einer der beiden konstanten Versorgungsspannungen (VCC, VEE) verbunden sind.

4. Schaltungsanordnung nach Anspruch 1 oder 2,
**dadurch gekennzeichnet,**
daß parallel zur Drain-Source-Strecke des als Gattereingang dienenden MOS-Schalttransistors (T1) die Drain-Source-Strecke mindestens eines weiteren ebenfalls als Gattereingang dienenden MOS-Schalttransistors (T11) geschaltet ist.

5. Schaltungsanordnung nach Anspruch 1 oder 2,
**dadurch gekennzeichnet,**
daß an der Verbindungsstelle wenigstens von einem der MOS-Schalttransistoren (T1, T2) zu den Bipolartransistoren (T4, T5) zwei weitere MOS-Schalttransistoren (T8, T9) derart zwischengeschaltet sind, daß die Sourceanschlüsse dieses dritten und vierten MOS-Schalttransistors (T8, T9) mit dem Drainanschluß des ersten oder zweiten MOS-Schalttransistors (T1, T2) verbunden sind und der Drainanschluß des dritten MOS-Schalttransistors (T8) zum Kollektoranschluß eines der Bipolartransistoren (T4, T5) und der Drainanschluß des vierten MOS-Schalttransistors (T9) zum Kollektoranschluß des anderen Bipolartransistors (T4, T5) geführt ist, und daß der Gateanschluß des dritten bzw. vierten MOS-Schalttransistors (T8, T9) als weiterer Gattereingang dient, während am noch verbleibenden Gateanschluß des vierten bzw. dritten MOS-Schalttransistors (T9, T8) eine eine Schaltschwelle für das zwischengeschaltete Gatter festlegende dritte Referenzspannung angeschaltet ist.

6. Schaltung nach Anspruch 5,
**dadurch gekennzeichnet,**
daß die die Gatterschaltschwelle festlegende zweite Referenzspannung (VB1) ohne Pegelverschiebung zusätzlich als dritte Referenzspannung verwendet wird.

# FIG 1

# FIG 2

# FIG 3

# FIG 4

# FIG 5